Europäisches Patentamt

European Patent Office

Office européen des brevets

(19)

(11) EP 0 599 686 B1

(12) **FASCICULE DE BREVET EUROPEEN**

(45) Date de publication et mention
de la délivrance du brevet:
**20.05.1998 Bulletin 1998/21**

(51) Int Cl.⁶: **H03C 1/60**

(21) Numéro de dépôt: **93402750.9**

(22) Date de dépôt: **09.11.1993**

(54) **Circuit numérique pour l'extraction des signaux de phase et d'enveloppe d'un signal à bande latérale unique**

Digitale Schaltung zum Extrahieren von Phasensignalen und umhüllenden Signalen aus einem Einseitenbandsignal

Digital circuit for extracting phase and envelope signals from a single side band signal

(84) Etats contractants désignés:
**DE GB**

(30) Priorité: **20.11.1992 FR 9213968**

(43) Date de publication de la demande:
**01.06.1994 Bulletin 1994/22**

(73) Titulaire: **THOMSON-CSF**
**75008 Paris (FR)**

(72) Inventeurs:
• **Darges, Bernard**
**F-92402 Courbevoie Cedex (FR)**

• **Helm, Jean-François**
**F-92402 Courbevoie Cedex (FR)**

(74) Mandataire: **Lincot, Georges et al**
**THOMSON-CSF-S.C.P.I.,**
**13, Avenue du Président**
**Salvador Allende**
**94117 Arcueil Cédex (FR)**

(56) Documents cités:
**EP-A- 0 202 985**     **EP-A- 0 360 990**
**US-A- 4 994 769**     **US-A- 5 115 468**

EP 0 599 686 B1

**Description**

La présente invention telle qu'elle est définie dans les revendications concerne un circuit numérique pour l'extraction des signaux de phase et d'enveloppe d'un signal à bande latérale unique.

Il est connu pour obtenir un signal modulé selon le principe de modulation à bande latérale unique, ci-après désigné par BLU, de séparer le signal BLU en ses deux composantes de phase et d'enveloppe afin de les appliquer à l'aide de deux voies distinctes sur une première et une deuxième entrée de l'étage de modulation d'un étage de puissance d'un émetteur.

De tels dispositifs sont par exemple décrits dans le brevet US 2 666 133 déposé au nom de Monsieur KHAN ou encore dans la demande de brevet européen 0 202 985 déposée au nom de la Demanderesse. D'autres dispositifs fonctionnant sur ce même principe sont également connus de la publication de Monsieur Léonard KHAN dans les revues Proceedings of the I.R.E. vol. 40 n° 7 de juillet 1950 ayant pour titre "Single sideband transmission by envelope elimination and restauration" ou encore de celle du même auteur ayant pour titre "Compatible single side band" également publiée dans la revue I.R.E. en juillet 1961.

Le principal inconvénient de ces dispositifs est qu'ils exigent dans les applications de radiodiffusion en ondes courtes notamment, un filtre à quartz très stable et par conséquent très onéreux pour effectuer le filtrage d'une des deux bandes latérales qui ne sont éloignées que de 300 Hz l'une de l'autre autour d'une fréquence porteuse située autour de quelques MHz. Bien que des filtres passe-bande entièrement numériques aient été envisagés, ceux-ci s'avèrent inapplicables du fait qu'ils sont très difficiles à réaliser. Les filtres récursifs voient en effet leurs performances limitées par les pôles de leur fonction de transfert possédant un module très proche du cercle unité qui conduisent à des instabilités. Par contre l'utilisation de filtres non récursifs qui est par essence même un garant de stabilité exige des temps de calcul d'autant plus importants que leur nombre de points de calculs est plus élevé. A titre d'exemple pour effectuer une atténuation de 40 dB de la bande latérale inférieure il faut avec cette solution utiliser un filtre à réponse impulsionnelle finie déterminée par 4000 points, ce qui est malheureusement incompatible avec les temps de transmission des récepteurs. Des solutions à filtre de Hilbert ne sont pas non plus envisageables car il est très difficile d'obtenir un gain de 1 avec un déphasage de 90°. Un tel dispositif est divulgué dans le document US-A 4 994 769. De plus pour obtenir des atténuations d'une bande latérale inférieure à 40 dB avec des variations de phase autour de - 90° n'excédant pas 1,14°, ces relations exigent théoriquement des fréquences d'échantillonnage de quelques mégahertz ce qui ne peut être réalisé en pratique.

Le but de l'invention est de pallier les inconvénients précités.

A cet effet, l'invention a pour objet un circuit numérique pour l'extraction des signaux de phase et d'enveloppe d'un signal à bande latérale unique obtenu à partir d'un signal basse fréquence échantillonné caractérisé en ce qu'il comprend des premiers moyens pour transformer le signal basse fréquence en un signal à bande latérale unique échantillonné couplés à des deuxièmes moyens pour séparer le signal BLU échantillonné en ses deux composantes de phase et d'enveloppe.

D'autres caractéristiques et avantages de l'invention apparaîtront à l'aide de la description qui suit faite en regard des dessins annexés qui représentent :

- la figure 1 un schéma fonctionnel d'un dispositif selon l'invention ;
- la figure 2 un gabarit de filtre mis en oeuvre par l'invention ;
- la figure 3 un exemple de signal sinusoïdal modulé en phase avec le dispositif selon l'invention ;
- la figure 4 un mode de réalisation d'un dispositif selon l'invention au moyen de quatre processeurs de signal.

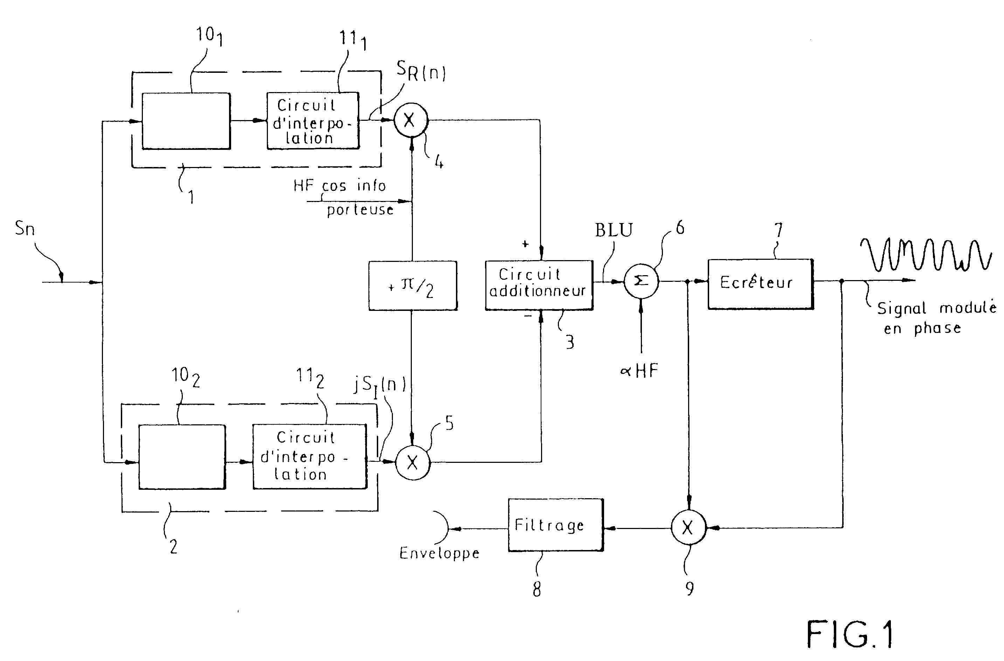

Le dispositif selon l'invention qui est représenté sous une forme fonctionnelle à la figure 1 comporte un premier 1 et un deuxième 2 réseau de filtrage alimentés tous les deux par une suite Sn d'échantillons numériques d'un signal BF de fréquence $F_{e1}$. Suivant cette organisation les réseaux 1 et 2 transforment la suite Sn d'échantillons en une suite complexe d'échantillons $S_{A(n)}$ tels que $S_{A(n)} = S_{R(n)} + JS_{I(n)}$. Les échantillons $S_{R(n)}$ de la partie réelle de la suite sont obtenus en sortie du réseau 1 et les échantillons $S_{I(n)}$ de la partie imaginaire sont obtenus en sortie du réseau 2. Les réseaux 1 et 2 sont couplés respectivement à une première entrée notée " + " et une deuxième entrée notée "-", d'un circuit additionneur 3 par l'intermédiaire de deux circuits multiplieurs 4 et 5 pour multiplier la suite complexe $S_{A(n)}$ par une suite de nombres complexes définis par la relation

$$\cos(2\pi n F_o) + j \sin(2\pi n F_o) \qquad (1)$$

en ne conservant que la partie réelle $S_{m(n)}$ de la suite ainsi obtenue. Ce calcul est effectué par le circuit multiplieur 4 qui effectue le produit $S_{R(n)}.\cos(2\pi n F_o)$ et par le circuit multiplieur 5 qui effectue le produit $S_{I(n)}.\sin(2\pi n F_o)$. La suite $S_{m(n)}$ qui est ainsi obtenue à la sortie du circuit additionneur 3 est un signal BLU modulé échantillonné de la forme

$$S_{m(n)} = S_{R(n)}.\cos(2\pi n F_o) - S_{I(n)} \sin(2\pi n F_o) \qquad (2)$$

Le signal $S_{m(n)}$ est appliqué à l'entrée d'un circuit sommateur 6 qui effectue la somme vectorielle dans le plan de Fresnel des échantillons $S_{m(n)}$ avec le signal de fréquence $F_o$. Ce signal est appliqué d'une part à l'entrée d'un écrêteur 7 qui fournit la composante de phase et d'autre part, à l'entrée d'un filtre 8 par l'intermédiaire d'un circuit multiplieur 9 pour extraire le signal d'enveloppe.

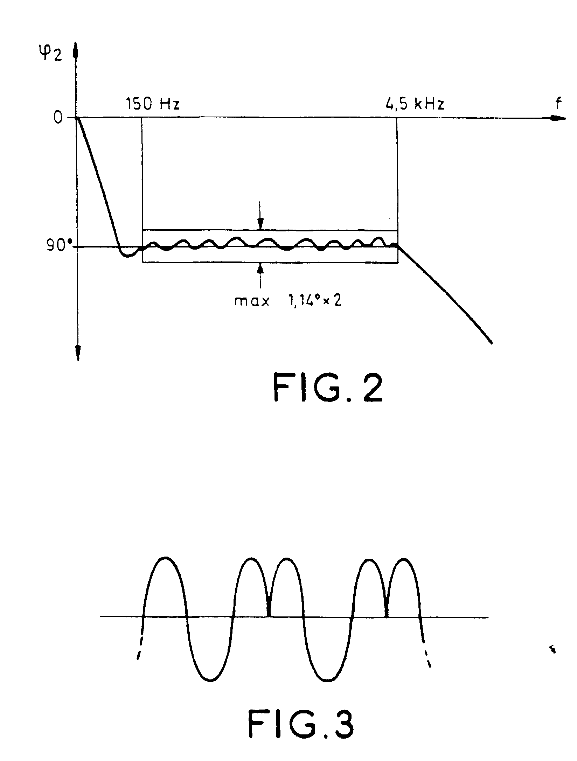

Les réseaux 1 et 2 comportent chacun un ensemble de 3 déphaseurs du premier ordre $10_1$ et $10_2$ dont le module des pôles est déterminé en fonction de la fréquence d'échantillonnage $F_{e1}$ du signal basse fréquence et un circuit d'interpolation $11_1$ et $11_2$ du signal obtenu à la sortie du déphaseur travaillant à la fréquence d'échantillonnage $F_{e2}$ de la porteuse haute fréquence HF du signal BF. Pour obtenir une atténuation de 40 dB entre les deux bandes latérales la constante propre à chaque déphaseur est déterminée de façon que la différence de phase $\varphi_1 - \varphi_2$ existant à la sortie de chacun des déphaseurs $10_1$ et $10_2$ soit inscrite à l'intérieur d'un gabarit de filtre présentant entre deux fréquences de coupure minimale et maximale par exemple 150 Hz à à 4,5 KHz avec un déphasage de - 90° n'excédant pas une variation de phase de $\pm$ 1,14° comme cela est représenté à la figure 2. L'écrêteur 7 est quant à lui déterminé pour fournir un signal sinusoïdal modulé en phase suivant une forme similaire à celle qui est représentée à la figure 3.

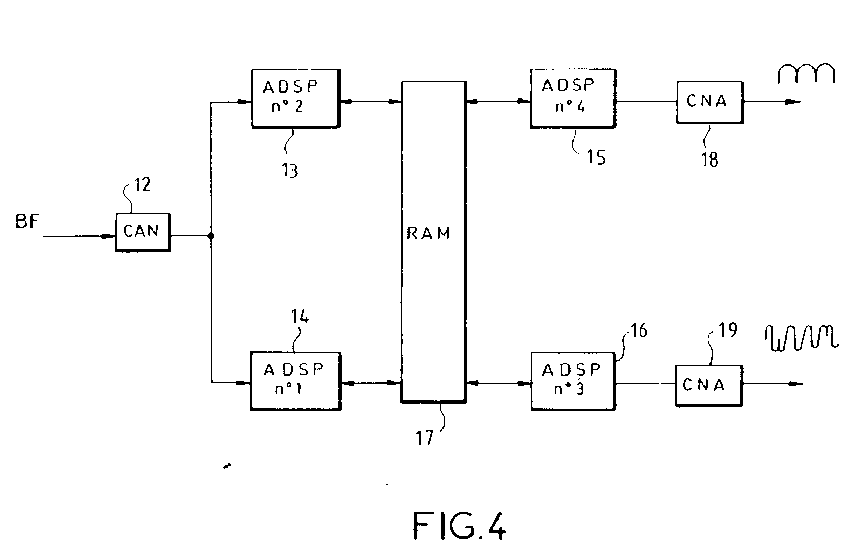

Naturellement le mode de réalisation du dispositif selon l'invention qui vient d'être décrit n'est pas unique, il va de soi que les fonctionnalités de ce dispositif peuvent être réalisées tout à fait autrement notamment en utilisant comme représenté à la figure 4 un ensemble de processeurs de signal notés respectivement 13, 14, 15 et 16 couplés par des entrées de données et d'adresses à une mémoire vive 17. Un convertisseur analogique-numérique 12 convertit le signal BF en échantillons de signaux numériques. Ces derniers sont appliqués aux entrées des processeurs 13 et 14. Ceux-ci calculent respectivement les suites de signaux réels $S_{R(n)}$ et imaginaires $S_{I(n)}$ de la relation (2) précédente. Ces échantillons obtenus sont mémorisés dans la mémoire vive 17 et leur amplitude est ensuite lissée par le processeur de signal 15 pour calculer le signal d'enveloppe du signal BLU. Les échantillons de signaux d'enveloppe correspondant sont appliqués à un convertisseur numérique-analogique 18 pour former le signal d'enveloppe du signal BLU. Le signal modulé en phase est calculé par le processeur du signal 16 à partir des échantillons mémorisés dans la mémoire vive 17 qui effectue un écrêtage des échantillons en détectant le signe de chacun de ceux-ci. Le signal sinusoïdal est reconstitué à partir des échantillons modulés en phase fournis par le processeur 16 au moyen d'un convertisseur numérique-analogique 19.

## Revendications

1. Circuit numérique pour l'extraction des signaux de phase et d'enveloppe d'un signal à bande latérale unique obtenu à partir d'un signal basse fréquence échantillonné caractérisé en ce qu'il comprend des premiers moyens (1, 2, 3, 4, 5 ; 13, 14) pour transformer le signal basse fréquence en un signal à bande latérale unique échantillonné couplés à des deuxièmes moyens (6, 7, 8 ; 15, 16, 17, 18) pour séparer le signal BLU échantillonné en ses deux composantes de phase et d'enveloppe.

2. Circuit selon la revendication 1 caractérisé en ce que les premiers moyens comprennent un premier (13) et un deuxième (14) processeurs de signal pour calculer à partir du signal basse fréquence échantillonné deux suites d'échantillons $S_{R(n)}$ et $S_{I(n)}$ respectivement à partie réel et imaginaire.

3. Circuit selon la revendication 2 caractérisé en ce que les deuxièmes moyens comportent des troisièmes moyens de mémorisation (17) pour mémoriser chacune des deux suites d'échantillons $S_{R(n)}$ et $S_{I(n)}$ couplés respectivement à un troisième (15) processeur de signal pour calculer le signal d'enveloppe du signal BLU et à un quatrième (16) processeur de signal pour calculer le signal modulé en phase.

4. Circuit selon la revendication 1 caractérisé en ce que les premiers moyens comportent :

   - un premier (1) et un deuxième (2) réseau de filtrage pour transi former le signal basse fréquence échantillonné $S_n$ en deux suites complexes d'échantillons à partie réelle $S_{R(n)}$ et imaginaire $S_{I(n)}$,
   - un circuit additionneur (3) couplé respectivement par une première entrée notée (+) et une deuxième entrée notée (-) aux sorties des premier (1) et deuxième (2) réseaux par l'intermédiaire de deux circuits multiplieurs (4 et 5) pour multiplier la suite complexe $S_{A(n)}$ formée des parties réelle et imaginaire $S_{R(n)}$ et $S_{I(n)}$ par une troisième suite de nombres complexes représentant la porteuse de fréquence $F_o$ du signal BLU et obtenir à la sortie du circuit additionneur (3) un signal BLU modulé échantillonné $S_{m(n)}$ de la forme :

$$S_{m(n)} = S_{R(n)} \cdot \cos(2\pi n F_o) - S_{I(n)} \sin(2\pi n F_o)$$

   - un circuit sommateur (6) couplé à la sortie du circuit additionneur (3) pour effectuer la somme vectorielle dans le plan de Fresnel des échantillons $S_{m(n)}$ avec la porteuse de fréquence $F_o$ et un circuit écrêteur (7) couplé à la sortie du circuit sommateur (6) pour fournir la composante de phase du signal BLU.

**5.** Circuit selon la revendication 4 caractérisé en ce qu'il comprend un circuit de filtrage (8) couplé à l'entrée et à la sortie du circuit écrêteur (7) par l'intermédiaire d'un circuit multiplieur (9) pour extraire la composante d'enveloppe du signal BLU.

**Patentansprüche**

1. Digitale Schaltung zur Extraktion der Phasen- und Hüllkurvensignale eines Einseitenbandsignals, das ausgehend von einem getasteten Niederfrequenzsignal erhalten wurde, dadurch gekennzeichnet, daß sie erste Mittel (1, 2, 3, 4, 5; 13, 14) zur Umwandlung des Niederfrequenzsignals in ein getastetes Einseitenbandsignal aufweist, die mit zweiten Mitteln (6, 7, 8; 15, 16, 17, 18) gekoppelt sind, um das getastete Einseitenbandsignal in seine Phasen- und Hüllkurvenkomponenten zu trennen.

2. Schaltung nach Anspruch 1, dadurch gekennzeichnet, daß die ersten Mittel einen ersten Signalprozessor (13) und einen zweiten Signalprozessor (14) zur Berechnung zweier Folgen von Tastproben $S_{R(n)}$ und $S_{I(n)}$ entsprechend dem reellen bzw. imaginären Teil ausgehend vom getasteten Niederfrequenzsignal enthalten.

3. Schaltung nach Anspruch 2, dadurch gekennzeichnet, daß die zweiten Mittel dritte Mittel (17) zur Speicherung je einer der Folgen $S_{R(n)}$ und $S_{I(n)}$ besitzen, die an einen dritten Signalprozessor (15) zur Berechnung des Hüllsignals des Einseitenbandsignals bzw. an einen vierten Signalprozessor (16) zur Berechnung des phasenmodulierten Signals gekoppelt sind.

4. Schaltung nach Anspruch 1, dadurch gekennzeichnet, daß die ersten Mittel aufweisen:

   - ein erstes Filternetz (1) und ein zweites Filternetz (2) zur Umwandlung des getasteten Niederfrequenzsignals $S_n$ in zwei komplexe Folgen von Tastproben entsprechend dem reellen Teil $S_{R(n)}$ und dem imaginären Teil $S_{I(n)}$,
   - eine Addierschaltung (3), die mit einem ersten Eingang (+) bzw. einem zweiten Eingang (-) an die Ausgänge der beiden Netze (1, 2) über zwei Multiplizierschaltungen (4, 5) gekoppelt ist, welche die komplexe Folge $S_{A(n)}$, die von reellen und imaginären Teilen $S_{R(n)}$ bzw. $S_{I(n)}$ gebildet wird, mit einer dritten Folge von komplexen Zahlen multiplizieren, die den Träger der Frequenz $F_0$ des Einseitenbandsignals repräsentieren, so daß sich am Ausgang des Addierers (3) ein getastetes Einseitenband-moduliertes Signal $S_m(n)$ folgender Form ergibt:

$$S_{m(n)} = S_{R(n)} \cdot \cos(2\pi n F_0) -$$

$$S_{I(n)} \cdot \sin(2\pi n F_0) \qquad (2)$$

   - eine Summierschaltung (6), die an den Ausgang der Addierschaltung (3) gekoppelt ist und die Vektorsumme der Tastproben $S_{m(n)}$ mit dem Träger der Frequenz $F_0$ in der Fresnel-Ebene bildet, wobei eine Begrenzerschaltung (7) an den Ausgang der Summierschaltung (6) gekoppelt ist, um die Phasenkomponente des Einseitenband-Signals zu liefern.

5. Schaltung nach Anspruch 4, dadurch gekennzeichnet, daß sie eine Filterschaltung (8) enthält, die an den Eingang und den Ausgang der Begrenzerschaltung (7) über eine Multiplizierschaltung (9) gekoppelt ist, um die Hüllkurvenkomponente des Einseitenband-Signals zu extrahieren.

**Claims**

1. Digital circuit for the extraction of the phase and envelope signals from a single sideband signal obtained from a sampled low-frequency signal, characterized in that it comprises first means (1, 2, 3, 4, 5; 13, 14) to convert the low-frequency signal into a sampled single sideband signal, coupled to second means (6, 7, 8; 15, 16, 17, 18) to separate the sampled SSB signal into its two components, the phase and envelope components.

2. Circuit according to Claim 1, characterized in that the first means comprise a first signal processor (13) and a second signal processor (14) for the computation, from the sampled low-frequency signal, of two sequences of samples $S_{R(n)}$ and $S_{I(n)}$ which are respectively real part samples and imaginary part samples.

3. Circuit according to Claim 2, characterized in that the second means comprise third means of storage (17) to store each of the two sequences of samples $S_{R(n)}$ and $S_{I(n)}$, respectively coupled to a third signal processor (15) to compute the envelope signal of the SSB signal and to a fourth signal processor (16) to compute the phase-modulated signal.

4. Circuit according to Claim 1, characterized in that the first means comprise:

   - a first filtering network (1) and a second filtering network (2) to convert the sampled low-frequency signal $S_n$ into two complex sequences of samples with real part $S_{R(n)}$ and imaginary part $S_{I(n)}$,

- an adder circuit (3) coupled respectively by a first input referenced (+) and a second input referenced (-) to the outputs of the first (1) and second (2) networks by means of two multiplier circuits (4 and 5) to multiply the complex sequence $S_{A(n)}$ formed from the real and imaginary parts $S_{R(n)}$ and $S_{I(n)}$ by a third sequence of complex numbers representing the frequency $F_0$ carrier of the SSB signal and to obtain, at the output of the adder circuit (3), a sampled, modulated SSB signal $S_{m(n)}$ having the form:

$$S_{m(n)} = S_{R(n)} \cdot \cos(2\pi n F_o) - S_{I(n)} \sin(2\pi n F_o)$$

- a summator circuit (6) coupled to the output of the adder circuit (3) to compute the vector sum in the Fresnel plane of the samples $S_{m(n)}$ with the carrier of frequency $F_o$ and a limiter circuit (7) coupled to the output of the summator circuit (6) to give the phase component of the SSB signal.

5. Circuit according to Claim 4, characterized in that it comprises a filter circuit (8) coupled to the input and to the output of the limiter circuit (7) by means of a multiplier circuit (9) to extract the envelope component of the SSB signal .

FIG.1

FIG. 2

FIG.3

EP 0 599 686 B1

FIG.4